# EUROPEAN PATENT APPLICATION

(11) **EP 4 497 787 A1**
(43) Date of publication of application: **29.01.2025**
(21) Application number: 23779627.1
(22) Date of filing: 15.03.2023
(51) Int. Cl.: C08L 101/00, B32B 15/08, B32B 27/30, C08K 3/01, C08K 3/013, C08L 63/00, H05K 1/03

(54) **RESIN COMPOSITION, INSULATING RESIN CURED BODY, LAMINATE, AND CIRCUIT SUBSTRATE**

(30) Priority: 31.03.2022 JP 2022060139
(71) Applicant: Denka Company Limited, Tokyo 103-8338 (JP)
(72) Inventor: GONDA, Yuhei, Tokyo 103-8338 (JP); KUMAGAI, Ryota, Tokyo 103-8338 (JP); ICHIKAWA, Isamu, Tokyo 103-8338 (JP); NAKAZAWA, Tomohiro, Tokyo 103-8338 (JP); KOGURE, Katsumichi, Tokyo 103-8338 (JP); NEBASHI, Ibuki, Tokyo 103-8338 (JP)
(74) Representative: Hoffmann Eitle
(86) International application number: PCT/JP2023/010132
(87) International publication number: WO 2023/189609

(57) **Abstract**

A resin composition contains a thermosetting resin, an inorganic filler material, a copolymer, and an inorganic ion scavenger, in which the copolymer has a (meth)acrylic monomer unit A having an anionic group, a (meth)acrylic monomer unit B having a cationic group, and a (meth)acrylic monomer unit C other than the (meth)acrylic monomer unit A and the (meth)acrylic monomer unit B, a content of the inorganic ion scavenger is 0.1 to 50 parts by mass with respect to 100 parts by mass of a sum total of the thermosetting resin and the copolymer, and a content of the copolymer is 0.01 to 10 parts by mass with respect to 100 parts by mass of the inorganic filler material.

## Description

### Technical Field

The present invention relates to a resin composition that is suitably used for the production of an insulating layer of a circuit substrate (metal base circuit substrate), an insulating resin cured body, a laminate, and a circuit substrate.

### Background Art

Various circuit substrates have been hitherto put to practical use as circuit substrates for mounting electronic and electrical components including semiconductor elements and forming hybrid integrated circuits. Circuit substrates are classified into resin circuit substrates, ceramic circuit substrates, metal base circuit substrates, and the like on the basis of the substrate material.

Resin circuit substrates are inexpensive; however, since the thermal conductivity of the substrates is low, use of the resin circuit substrates is limited to use applications that utilize a relatively small amount of electric power. Ceramic circuit substrates are appropriate for use applications that utilize a relatively large amount of electric power due to the features of ceramics having high electrical insulation properties and high heat resistance; however, the ceramic circuit substrates have a disadvantage of being expensive. On the other hand, metal base circuit substrates have intermediate properties between the two and are suitable for general-purpose use applications that utilize a relatively large amount of electric power, for example, use applications such as inverters for refrigerators, inverters for commercial air conditioners, power sources for industrial robots, and power sources for automobiles.

For example, Patent Literature 1 discloses a method of obtaining a circuit substrate having excellent stress relaxation properties, heat resistance, moisture resistance, and heat dissipation properties by using a composition for a circuit substrate containing a specific epoxy resin, a curing agent, and an inorganic filler material as essential components.

### Citation List

### Patent Literature

Patent Literature 1: Japanese Unexamined Patent Publication No. 2008-266533

### Summary of Invention

### Technical Problem

If ceramic circuit substrates could be replaced with metal base circuit substrates, improvement of productivity could be expected. Furthermore, ceramic circuit substrates have a problem that solder cracks are easily generated on the substrates during heat cycles; however, suppression of the occurrence of solder cracks can be expected when ceramic circuit substrates are replaced with metal base circuit substrates. On the other hand, since ceramic circuits are suitable for use applications that utilize a relatively large amount of electric power, when replacing ceramic circuit substrates with metal base circuit substrates, metal base circuit substrates are required to have improved insulation reliability (particularly insulation reliability under high temperature conditions) against the application of high direct current voltages.

Thus, it is an object of the present invention to provide a resin composition capable of forming an insulating layer having excellent insulation reliability against the application of high direct current voltages under high temperature (150°C) conditions. Furthermore, it is another object of the present invention to provide an insulating resin cured body, which is a cured body of the resin composition, and a laminate and a circuit substrate obtained using the insulating resin cured body.

### Solution to Problem

The present invention includes embodiments described below.
(1) A resin composition containing:
   a thermosetting resin;
   an inorganic filler material;
   a copolymer; and
   an inorganic ion scavenger,
   wherein the copolymer has a (meth)acrylic monomer unit A having an anionic group, a (meth)acrylic monomer unit B having a cationic group, and a (meth)acrylic monomer unit C other than the (meth)acrylic monomer unit A and the (meth)acrylic monomer unit B,
   a content of the inorganic ion scavenger is 0.1 to 50 parts by mass with respect to 100 parts by mass of the thermosetting resin, and
   a content of the copolymer is 0.01 to 10 parts by mass with respect to 100 parts by mass of the inorganic filler material.
(2) The resin composition according to (1), wherein the inorganic filler material has a thermal conductivity of 20 W/m·K or greater.
(3) The resin composition according to (1) or (2), wherein a content of the inorganic filler material is 30 to 70% by volume with respect to a total volume of the resin composition.
(4) The resin composition according to any one of (1) to (3), wherein the inorganic ion scavenger includes at least one selected from the group consisting of Al, Mg, Bi, Zr, Sb, Sn, Ti, and Zn.
(5) The resin composition according to any one of (1) to (4), wherein the inorganic ion scavenger has an average particle size of 0.05 to 10 µm.
(6) The resin composition according to any one of (1) to (5), wherein a mass ratio of the inorganic ion scavenger to the copolymer is 0.001 to 10000.
(7) The resin composition according to any one of (1) to (6), wherein the resin composition has a peak within a range of 2θ = 11 to 15° in X-ray diffraction measurement.
(8) The resin composition according to any one of (1) to (7), wherein the thermosetting resin is an epoxy resin.
(9) An insulating resin cured body, which is a cured body of the resin composition according to any one of (1) to (8).
(10) A laminate comprising:
   a first metal layer;
   an insulating layer disposed on one surface of the first metal layer; and
   a second metal layer disposed on a surface of the insulating layer, the surface being on an opposite side of the first metal layer,
   wherein the insulating layer is the insulating resin cured body according to (9).
(11) A circuit substrate comprising:
   a metal layer;
   an insulating layer disposed on one surface of the metal layer; and
   a metal circuit part disposed on a surface of the insulating layer, the surface being on an opposite side of the metal layer,
   wherein the insulating layer is the insulating resin cured body according to (9).

### Advantageous Effects of Invention

According to the present invention, a resin composition capable of forming an insulating layer having excellent insulation reliability against the application of high direct current voltages under high temperature (150°C) conditions, is provided. Furthermore, according to the present invention, an insulating resin cured body, which is a cured body of the resin composition, and a laminate and a circuit substrate using the insulating resin cured body, are provided.

### Brief Description of Drawings

[FIG. 1] FIG. 1 is a cross-sectional view illustrating an embodiment of a laminate.
[FIG. 2] FIG. 2 is a cross-sectional view illustrating an embodiment of a circuit substrate.

### Description of Embodiments

Hereinafter, suitable embodiments of the present invention will be described in detail.

An embodiment of the present invention is a resin composition containing a thermosetting resin, an inorganic filler material, a copolymer, and an inorganic ion scavenger.

Examples of the thermosetting resin include a silicone resin, an epoxy resin, a phenol resin, a cyanate resin, a melamine resin, a urea resin, a thermosetting polyimide resin, and an unsaturated polyester resin. The thermosetting resin may include an epoxy resin. The thermosetting resin can be used singly or in combination of two or more kinds thereof.

From the viewpoint of further improving insulation properties, the content of the thermosetting resin may be 10% by mass or more, 20% by mass or more, or 25% by mass or more, with respect to the total mass of the resin composition. From the viewpoint of improving thermal conductivity, the content of the thermosetting resin may be 50% by mass or less, 40% by mass or less, or 30% by mass or less, with respect to the total mass of the resin composition.

The inorganic filler material may be, for example, a known inorganic filler material used in use applications that require insulation properties and thermal conductivity (provided that those that fall under the category of inorganic ion scavengers as will be described below are excluded). The inorganic filler material may include, for example, one or more selected from the group consisting of aluminum oxide (alumina), silicon oxide, silicon nitride, boron nitride, aluminum nitride, and magnesium oxide, and from the viewpoint of having more excellent insulation reliability in a high humidity environment, the inorganic filler material may include one or more selected from the group consisting of aluminum oxide, silicon oxide, silicon nitride, boron nitride, and aluminum nitride, or may include one or more selected from the group consisting of aluminum oxide, boron nitride, and aluminum nitride.

The shape of the inorganic filler material may be, for example, a particulate shape, a flaky shape, or a polygonal shape. From the viewpoint of improving thermal conductivity, the average particle size of the inorganic filler material may be 0.05 µm or more, 0.1 µm or more, 5 µm or more, 10 µm or more, 20 µm or more, 30 µm or more, or 40 µm or more, and from the viewpoint of further improving insulation properties, the average particle size may be 200 µm or less, 150 µm or less, 100 µm or less, 80 µm or less, 60 µm or less, or 40 µm or less. In the present specification, the average particle size of the inorganic filler material means the d50 diameter in a volume-based particle size distribution of the inorganic filler material. The volume-based particle size distribution of the inorganic filler material is measured using a laser diffraction type particle size distribution analyzer.

The thermal conductivity of the inorganic filler material may be 20 W/m·K or greater, 50 W/m·K or greater, 100 W/m·K or greater, or 150 W/m·K or greater, and may be 35000 W/m·K or less, 2000 W/m·K or less, 600 W/m·K or less, 300 W/m·K or less, or 200 W/m·K or less.

The inorganic filler material may contain two or more kinds of inorganic filler materials having average particle sizes that are different from each other. For example, the inorganic filler material may include a first inorganic filler material having an average particle size of 25 µm or more and a second inorganic filler material having an average particle size of 4 µm or less. According to such an inorganic filler material, when gaps between the first inorganic filler material are filled with the second inorganic filler material, the filling density increases, and this contributes to an improvement in thermal conductivity.

The average particle size of the first inorganic filler material may be 30 µm or more or 40 µm or more, and may be 200 µm or less or 150 µm or less. The average particle size of the second inorganic filler material may be 3.5 µm or less or 3 µm or less, and may be 0.05 µm or more or 0.1 µm or more.

From the viewpoint of improving thermal conductivity, the content of the inorganic filler material may be 30% by mass or more, 40% by mass or more, 50% by mass or more, or 60% by mass or more, with respect to the total mass of the resin composition. From the viewpoint of further improving insulation properties, the content of the inorganic filler material may be 80% by mass or less, 75% by mass or less, 70% by mass or less, or 65% by mass or less, with respect to the total mass of the resin composition, and from the viewpoint of obtaining a metal base substrate having more excellent insulation reliability against high voltages in a high-temperature environment or a high-temperature high-humidity environment, the content is preferably 65% by mass or less.

From the viewpoint of improving thermal conductivity, the content of the inorganic filler material may be 20% by volume or more, 30% by volume or more, 40% by volume or more, 45% by volume or more, or 50% by volume or more, with respect to the total volume of the resin composition. From the viewpoint of further improving insulation properties, the content of the inorganic filler material may be 80% by volume or less, 70% by volume or less, 60% by volume or less, 55% by volume or less, or 50% by volume or less, with respect to the total volume of the resin composition, and from the viewpoint of obtaining a metal base substrate having more excellent insulation reliability against high voltages in a high-temperature environment or a high-temperature high-humidity environment, the content is preferably 55% by volume or less. The content of the inorganic filler material may be 20 to 80% by volume or 30 to 70% by volume with respect to the total volume of the resin composition.

The copolymer contains a (meth)acrylic monomer unit A having an anionic group (hereinafter also referred to as "unit A" and a monomer giving the unit A is also referred to as "monomer A"), a (meth)acrylic monomer unit B having a cationic group (hereinafter also referred to as "unit B" and a monomer giving the unit B is also referred to as "monomer B"), and a (meth)acrylic monomer unit C other than the (meth)acrylic monomer unit A and the (meth)acrylic monomer unit B (hereinafter also referred to as "unit C" and a monomer giving the unit C is also referred to as "monomer C"). The copolymer may contain a (meth)acrylic monomer unit (unit X) having both an anionic group and a cationic group. In this case, it is defined that the unit X corresponds to the unit A and also corresponds to the unit B. In other words, the copolymer having the unit X is defined as having both the unit A and the unit B.

In the present specification, the "monomer" means a monomer having a polymerizable group before polymerization. The "monomer unit" means a structural unit derived from the monomer and constituting a copolymer. The "(meth)acrylic monomer" means a monomer having a (meth)acryloyl group. "(meth)acrylic monomer" means an acrylic monomer and a methacrylic monomer corresponding thereto, and similar expressions such as "(meth)acryloyl group" have the same meaning.

The copolymer has one type or two or more types of each of the unit A, the unit B, and the unit C. The copolymer may be a random copolymer or or may be a block copolymer. Each of the monomer A, the monomer B, and the monomer C may be a monomer having one (meth)acryloyl group (monofunctional (meth)acrylic monomer), may be a monomer having two or more (meth)acryloyl groups (polyfunctional (meth)acrylic monomer), and is preferably a monofunctional (meth)acrylic monomer.

The anionic group contained in the unit A is, for example, one or more selected from the group consisting of a carboxyl group, a phosphoric acid group, a phenolic hydroxy group, and a sulfonic acid group. From the viewpoint of further improving the dispersibility of the inorganic filler, the anionic group is preferably one or more selected from the group consisting of a carboxy group, a phosphoric acid group, and a phenolic hydroxy group.

From the viewpoint of further improving the dispersibility of the inorganic filler, the unit A preferably further has an electron withdrawing group bonded to an anionic group. The electron withdrawing group has a function of stabilizing the anion of the anionic group. Examples of the electron withdrawing group include a halogen group (also referred to as halogeno group). Examples of the anion group to which an electron withdrawing group is bonded include a group in which a halogen group is bonded to the carbon atom at the α-position of a carboxyl group.

The unit A may have no electron donating group bonded to an anionic group. The electron donating group may destabilize the anion of the anionic group. Examples of the electron donating group include a methyl group.

Examples of the monomer A include acrylic acid, methacrylic acid, acid phosphoxy propyl methacrylate, acid phosphoxy polyoxyethylene glycol monomethacrylate, acid phosphoxy polyoxypropylene glycol monomethacrylate, phosphoric acid-modified epoxy acrylates, 2-acryloyloxyethyl acid phosphate, 2-methacryloyloxyethyl acid phosphate, 4-hydroxyphenyl acrylate, 4-hydroxyphenyl methacrylate, 2-methacryloyloxyethylsuccinic acid and 2-acrylamido-2-methylpropanesulfonic acid. From the viewpoint of further improving the dispersibility of the inorganic filler, the monomer A is preferably one or more selected from the group consisting of acrylic acid, 2-methacryloyloxyethyl phosphate, 4-hydroxyphenyl methacrylate, and 2-acrylamido-2-methylpropanesulfonic acid, and more preferably acrylic acid.

The cationic group contained in the unit B is, for example, one or more selected from the group consisting of a primary amino group, a secondary amino group, a tertiary amino group, and a quaternary ammonium salt group. The cationic group is preferably a tertiary amino group from the viewpoint of further improving the dispersibility of the inorganic filler.

From the viewpoint of further improving the dispersibility of the inorganic filler, the unit B preferably further has an electron donating group bonded to a cationic group. The electron donating group has a function of stabilizing the cation of the cationic group. Examples of the electron donating group include a methyl group. Examples of the cation group to which an electron donating group is bonded include groups in which a methyl group is bonded to the carbon atom at the α-position of an amino group.

The unit B may have no electron withdrawing group bonded to the cationic group. The electron withdrawing group may destabilize the cation of the cationic group. Examples of the electron withdrawing group include a carboxy group.

Examples of the monomer B include 1-aminoethyl acrylate, 1-aminopropyl acrylate, 1-aminoethyl methacrylate, 1-aminopropyl methacrylate, dimethylaminoethyl methacrylate, diethylaminoethyl methacrylate, t-butylaminoethyl (meth)acrylate, dimethylaminoethyl methacrylate quaternary salts, 1,2,2,6,6-pentamethyl-4-piperidyl methacrylate, 2,2,6,6-tetramethyl-4-piperidyl methacrylate, and dimethyl aminoethyl acrylate benzylchlrolide quaternary salt. From the viewpoint of further improving the dispersibility of the inorganic filler, the monomer B is preferably one or more selected from the group consisting of 1,2,2,6,6-pentamethyl-4-piperidyl methacrylate and 2,2,6,6-tetramethyl-4-piperidyl methacrylate, and more preferably 1,2,2,6,6-pentamethyl-4-piperidyl methacrylate.

The unit C is a (meth)acrylic monomer containing neither a cationic group nor an anionic group. In addition to the (meth)acryloyl group, the unit C may have an amphiphilic group, a hydrophobic group, or a hydrophilic group. Examples of the amphiphilic group include an oxyalkylene group. Examples of the hydrophobic group include a siloxane group and a hydrocarbon group. Examples of the hydrophilic group include a phosphoric acid ester group. The hydrocarbon group referred to herein does not include a methyl group constituting a methacryloyl group (hereinafter, the same applies to the hydrocarbon group in the unit C).

When the resin composition further contains a resin, the unit C contains one or more selected from the group consisting of an oxyalkylene group, a siloxane group, and a hydrocarbon group, and more preferably contains one or more selected from the group consisting of a siloxane group and a hydrocarbon group, from the viewpoint of affinity or compatibility between the copolymer and the resin.

Examples of the (meth)acrylic monomer having an oxyalkylene group include ethoxycarbonylmethyl (meth)acrylate, phenol ethylene oxide-modified (meth)acrylate, phenol (ethylene oxide 2 mol-modified) (meth)acrylate, phenol (ethylene oxide 4 mol-modified) (meth)acrylate, p-cumylphenol ethylene oxide-modified (meth)acrylate, nonylphenol ethylene oxide-modified (meth)acrylate, nonylphenol (ethylene oxide 8 mol-modified) (meth)acrylate, nonylphenol (propylene oxide 2.5 mol-modified) acrylate, 2-ethylhexylcarbitol (meth)acrylate, ethylene oxide-modified phthalic acid (meth)acrylate, ethylene oxide-modified succinic acid (meth)acrylate, and tetrahydrofurfuryl (meth)acrylate.

Examples of the (meth)acrylic monomer having a siloxane group include α-butyl-ω-(3-methacryloxypropyl) polydimethylsiloxane. Examples of the (meth)acrylic monomer having a hydrocarbon group include methyl (meth)acrylate, ethyl (meth)acrylate, propyl (meth)acrylate, butyl (meth)acrylate, 2-ethylhexyl (meth)acrylate, isooctyl (meth)acrylate, isodecyl (meth)acrylate, lauryl (meth)acrylate, stearyl (meth)acrylate, phenyl (meth)acrylate, cyclohexyl (meth)acrylate, dicyclopentanyl (meth)acrylate, dicyclopentenyl (meth)acrylate, dicyclopentenyloxyethyl (meth)acrylate, isobornyl (meth)acrylate, and methoxylated cyclodecatriene (meth)acrylate.

Examples of the (meth)acrylic monomer having a phosphoric acid ester group include a (meth)acryloyloxyehtyl dialkyl phosphate.

In addition to the above, the monomer C may be, for example, a (meth)acrylic monomer having a hydroxy group. Examples of the (meth)acrylic monomer having a hydroxy group include 2-hydroxyethyl (meth)acrylate, 2-hydroxypropyl (meth)acrylate, 3-hydroxypropyl (meth)acrylate, 4-hydroxybutyl (meth)acrylate, 2-hydroxy-3-phenoxypropyl (meth)acrylate, and 3-chloro-2-hydroxypropyl (meth)acrylate.

The monomer C may be, for example, a (meth)acrylic monomer having an amide bond. Examples of the (meth)acrylic monomer having an amide bond include N,N-dimethyl (meth) acrylamide, N,N-diethyl (meth) acrylamide, N-isopropyl (meth) acrylamide, diacetone (meth) acrylamide, and acryloylmorpholine.

The monomer C may be, for example, a polyfunctional (meth)acrylic monomer. Examples of the polyfunctional (meth)acrylic monomer include 1,3-butylene glycol di(meth)acrylate, 1,4-butanediol di(meth)acrylate, 1,6-hexanediol di(meth)acrylate, 1,9-nonanediol di(meth)acrylate, neopentyl glycol di(meth)acrylate, dicyclopentanyl di(meth)acrylate, 2-ethyl-2-butyl-propanediol (meth)acrylate, neopentyl glycol-modified trimethylolpropane di(meth)acrylate, stearic acid-modified pentaerythritol di(meth)acrylate, 2-(1,2-cyclohexacarboximide) ethyl (meth)acrylate, hexanediol di(meth)acrylate, and polyfunctional (meth)acrylate having a bisphenol structure.

The content of the unit A may be 0.03% by mole or more, 0.1% by mole or more, 0.5% by mole or more, 1% by mole or more, 2% by mole or more, 3% by mole or more, 4% by mole or more, or 5% by mole or more, and may be 70% by mole or less, 60% by mole or less, 50% by mole or less, 40% by mole or less, 30% by mole or less, 20% by mole or less, 15% by mole or less, 10% by mole or less, or 5% by mole or less, based on 100% by mole of the total of the unit A, the unit B, and the unit C (in other words, the total of all monomer units in the copolymer; the same applies hereinafter). When the content of the unit A is 0.03% by mole or more, the dispersibility of the inorganic filler tends to be further improved. When the content of the unit A is 70% by mole or less, the viscosity of the resin composition tends to be further reduced, and the handleability of the resin composition tends to be further improved.

The content of the unit B may be 0.02% by mole or more, 0.05% by mole or more, 0.07% by mole or more, or 0.1% by mole or more, and may be 20% by mole or less, 10% by mole or less, 5% by mole or less, 3% by mole or less, 1% by mole or less, 0.5% by mole or less, or 0.1% by mole or less, based on 100% by mole of the total of the unit A, the unit B, and the unit C. When the content of the unit B is 0.02% by mole or more, the affinity of the copolymer for the inorganic filler tends to be more favorable. When the content of the unit B is 20% by mole or less, there is a tendency that the viscosity of the resin composition is further decreased and the handling property of the resin composition is further improved.

The content of the unit C may be 10% by mole or more, 20% by mole or more, 30% by mole or more, 40% by mole or more, 50% by mole or more, 60% by mole or more, 70% by mole or more, 80% by mole or more, 90% by mole or more, 92% by mole or more, or 94% by mole or more, and may be 99.8% by mole or less, 99% by mole or less, 98% by mole or less, 97% by mole or less, 96% by mole or less, or 95% by mole or less, based on 100% by mole of the total of the unit A, the unit B, and the unit C. When the content of the unit C is 10% by mole or more, the viscosity of the resin composition tends to be further reduced, and the handleability of the resin composition tends to be further improved. When the content of the unit C is 99.8% by mole or less, the affinity of the copolymer for the inorganic filler tends to be more favorable.

The total content of the unit A and the unit B may be 0.05% by mole or more, 0.2% by mole or more, 1% by mole or more, 2% by mole or more, 3% by mole or more, 4% by mole or more, or 5% by mole or more, and 90% by mole or less, 80% by mole or less, 70% by mole or less, 60% by mole or less, 50% by mole or less, 40% by mole or less, 30% by mole or less, 20% by mole or less, 10% by mole or less, 8% by mole or less, or 6% by mole or less, based on 100% by mole of the total of the unit A, the unit B, and the unit C. When the total content of the unit A and the unit B is 0.05% by mole or more, the dispersibility of the inorganic filler tends to be further improved. When the total content of the unit A and the unit B is 90% by mole or less, the handleability of the resin composition tends to be further improved.

The molar ratio of the unit A to the unit B (unit A / unit B) may be 0.01 or more, 0.9 or more, 1 or more, 5 or more, 10 or more, 20 or more, 30 or more, 40 or more, or 50 or more, and may be 200 or less, 150 or less, 100 or less, 90 or less, 80 or less, 70 or less, 60 or less, 50 or less, 40 or less, 30 or less, 20 or less, 15 or less, or 10 or less. When the molar ratio of the unit A to the unit B is within the above range, the dispersibility of the inorganic filler tends to be further improved.

The weight average molecular weight of the copolymer may be 1,000 or more, 5,000 or more, 7,000 or more, 10,000 or more, 20,000 or more, 30,000 or more, 40,000 or more, or 50,000 or more, and may be 1,000,000 or less, 500,000 or less, 300,000 or less, 100,000 or less, 90,000 or less, 80,000 or less, 70,000 or less, or 60,000 or less. When the weight average molecular weight of the copolymer is 1,000 or more, the dispersibility of the inorganic filler can be maintained and an increase in the hardness of the resin composition can be suppressed even when the resin composition is stored for a long time in a high-temperature environment. In addition, the shape retention of the resin composition is improved, and when the reisn composition is applied to an inclined surface or a vertical surface, displacement or dripping of the composition is suppressed. When the weight average molecular weight of the copolymer is 1,000,000 or less, there is a tendency that the viscosity of the resin composition is further reduced and the handling property of the resin composition is further improved. The weight average molecular weight of the copolymer is determined as a weight average molecular weight in terms of standard polystyrene by using a gel permeation chromatography (GPC) method.

The copolymer is obtained by polymerizing the monomer A, the monomer B, and the monomer C by a known polymerization method. Examples of the polymerization method include radical polymerization and anionic polymerization. The polymerization method is preferably radical polymerization.

The polymerization initiator used for radical polymerization may be a thermal polymerization initiator or a photopolymerization initiator. Examples of the thermal polymerization initiator include azo compounds such as azobisisobutyronitrile; and organic peroxides such as benzoyl peroxide, tert-butyl hydroperoxide, and di-tert-butyl peroxide. Examples of the photopolymerization initiator include benzoin derivatives. The polymerization initiator may be a known polymerization initiator used for living radical polymerization such as ATRP or RAFT.

The polymerization conditions can be appropriately adjusted depending on the type of the monomer, the polymerization initiator, and the like. When the copolymer is a random copolymer, each monomer may be mixed in advance and polymerized. When the copolymer is a block copolymer, each monomer may be added sequentially to the polymerization system.

The content of the copolymer is 0.01 to 10 parts by mass with respect to 100 parts by mass of the inorganic filler material. When the content of the copolymer is within this range, a resin composition capable of forming an insulating layer having excellent insulation reliability against the application of high direct current voltages under high temperature (150°C) conditions, is obtained. The content of the copolymer may be 0.05 parts by mass or more, 0.1 parts by mass or more, 0.5 parts by mass or more, 1 part by mass or more, 2 parts by mass or more, 3 parts by mass or more, or 4 parts by mass or more, and may be 9 parts by mass or less, 8 parts by mass or less, 7 parts by mass or less, 6 parts by mass or less, 5 parts by mass or less, or 4 parts by mass or less, with respect to 100 parts by mass of the inorganic filler material.

The content of the copolymer may be 0.1% by mass or more, 0.5% by mass or more, 1% by mass or more, 2% by mass or more, or 2.5% by mass or more, and may be 10% by mass or less, 8% by mass or less, 6% by mass or less, 5% by mass or less, 4% by mass or less, or 3% by mass or less, with respect to the total mass of the resin composition.

The inorganic ion scavenger is an inorganic material having a function of trapping at least one of cations and anions (having ion trapping property). The term "ion trapping property" as used in the present specification means a property of adsorbing ions to be trapped onto the surface or the like of an inorganic material, or a property of introducing ions to be trapped into the structure of an inorganic material by ion exchange between ions within the structure of the inorganic material and the ions to be trapped. Examples of the ions to be trapped by the inorganic ion scavenger include cations such as Na ion, Cu ion, and Ag ion; and anions such as Cl ion and Br ion.

The inorganic ion scavenger may include, for example, at least one selected from the group consisting of Al, Mg, Bi, Zr, Sb, Sn, Ti, and Zn, or may include at least one selected from the group consisting of Al, Mg, Bi, Zr, Sb, and Zn. The inorganic ion scavenger may also be, for example, an oxide, an acid chloride, or a hydrate thereof containing at least one of these metal elements. The inorganic ion scavenger may include two or more kinds of these metal elements.

Examples of the inorganic ion scavenger include an anion exchanger that traps anions, a cation exchanger that traps cations, and an amphoteric ion exchanger that traps both anions and cations. The inorganic ion scavenger may be used singly or in combination of two or more kinds thereof, and for example, the amphoteric ion exchanger may be a mixture of an anion exchanger and a cation exchanger.

The anion exchanger may be an inorganic material containing at least one selected from the group consisting of Al, Mg, Bi, Zr, and Zn. Specific examples of the anion exchanger include IXE-500 (Bi-based), IXE-530 (Bi-based), IXE-550 (Bi-based), IXE-700 (Mg, Al-based), IXE-700F (Mg, Al-based), IXE-770 (Mg, Al-based), IXE-770D (Mg, Al-based), IXE-702 (Al-based), IXE-800 (Zr-based), and IXE-1000 (Zn-based) (all manufactured by TOAGOSEI CO., LTD.).

The cation exchanger may be an inorganic material containing at least one selected from the group consisting of Zr, Sn, and Ti. Specific examples of the cation exchanger include IXE-100 (Zr-based), IXE-200 (Sn-based), IXE-300 (Sb-based), and IXE-400 (Ti-based) (all manufactured by TOAGOSEI CO., LTD.).

The amphoteric ion exchanger may be an inorganic material containing at least one selected from the group consisting of Al, Mg, Bi, Zr, and Sb. Specific examples of the amphoteric ion exchanger include IXE-1320 (Mg, Al-based), IXE-600 (Sb, Bi-based), IXE-633 (Bi-based), IXE-680 (Bi-based), IXE-6107 (Zr, Bi-based), IXE-6136 (Zr, Bi-based), IXEPLAS-A1 (Zr, Mg, Al-based), IXEPLAS-A2 (Zr, Mg, Al-based), and IXEPLAS-B1 (Zr, Bi-based) (all manufactured by TOAGOSEI CO., LTD.).

The average particle size of the inorganic ion scavenger may be 0.05 µm or more, 0.1 µm or more, 0.15 µm or more, 0.2 µm or more, 0.3 µm or more, 0.4 µm or more, or 0.5 µm or more, and may be 10 µm or less, 5 µm or less, 3 µm or less, 2 µm or less, 1.5 µm or less, or 1 µm or less. The average particle size of the inorganic ion scavenger may be 0.05 to 10 µm. The average particle size of the inorganic ion scavenger can be measured by a laser diffraction scattering method.

The content of an inorganic ion scavenger containing at least one selected from the group consisting of Al, Mg, Bi, Zr, Sb, and Zn may be 80% by mass or more, 90% by mass or more, or 95% by mass or more, with respect to the total mass of the inorganic ion scavenger. The content of the inorganic ion scavenger containing at least one selected from the group consisting of Al, Mg, Bi, Zr, Sb, and Zn may be substantially 100% by mass with respect to the total mass of the inorganic ion scavenger.

The content of the inorganic ion scavenger is 0.1 to 50 parts by mass with respect to a total of 100 parts by mass of the thermosetting resin and the copolymer. From the viewpoint of obtaining a resin composition capable of forming an insulating layer having more excellent insulation reliability against the application of high direct current voltages under high temperature (150°C) conditions, the content of the inorganic ion scavenger may be 0.3 parts by mass or more, 0.5 parts by mass or more, 1 part by mass or more, 2 parts by mass or more, 3 parts by mass or more, or 4 parts by mass or more, and may be 40 parts by mass or less, 30 parts by mass or less, 20 parts by mass or less, 15 parts by mass or less, or 10 parts by mass or less, with respect to a total of 100 parts by mass of the thermosetting resin and the copolymer.

From the viewpoint of obtaining a resin composition capable of forming an insulating layer having more excellent insulation reliability against the application of high direct current voltages under high temperature (150°C) conditions, the content of the inorganic ion scavenger may be 0.05% by mass or more, 0.1% by mass or more, 0.5% by mass or more, 1% by mass or more, 1.2% by mass or more, or 1.4% by mass or more, and may be 30% by mass or less, 20% by mass or less, 15% by mass or less, 10% by mass or less, 8% by mass or less, 6% by mass or less, or 4% by mass or less, with respect to the total mass of the resin composition.

From the viewpoint of obtaining a resin composition capable of forming an insulating layer having more excellent insulation reliability against the application of high direct current voltages under high temperature (150°C) conditions, the mass ratio of the inorganic ion scavenger to the copolymer (content based on the mass of the inorganic ion scavenger/content based on the mass of the copolymer) may be 0.005 or more, 0.01 or more, or 0.05 or more, and may be 1000 or less, 100 or less, or 50 or less. The mass ratio of the inorganic ion scavenger to the copolymer may be 25 or less, 10 or less, 5 or less, or 3 or less. The mass ratio of the inorganic ion scavenger to the copolymer may be 0.001 to 10000.

The resin composition may further contain a curing agent that cures the thermosetting resin. The curing agent is appropriately selected depending on the type of the thermosetting resin. Examples of the curing agent in a case where the thermosetting resin is an epoxy resin include an amine-based resin, an acid anhydride-based resin, and a phenol-based resin. The curing agent is used singly or in combination of two or more kinds thereof.

The content of the curing agent may be 1% by mass or more or 3% by mass or more, and may be 10% by mass or less or 5% by mass or less, with respect to the total mass of the resin composition.

The resin composition may further contain other components. Examples of the other components include a curing accelerator, a coupling agent, a leveling agent, an antioxidant, an antifoaming agent, a wetting agent, a dispersant, and a stabilizer.

The resin composition is obtained by mixing a thermosetting resin, an inorganic filler material, a copolymer, and an inorganic ion scavenger (additionally, a curing agent and other components that are used as necessary). The mixing may be performed using, for example, a planetary stirrer, a universal mixing stirrer, a kneader, or a hybrid mixer.

The resin composition may have a peak within the range of 2θ = 11 to 15° in X-ray diffraction measurement. The peak position in the X-ray diffraction measurement of the resin composition can be checked by, for example, producing a cured body of the resin composition and performing X-ray diffraction measurement for the cured body. The resin composition may have a peak at the position of 2θ = 11.5 to 14.5 or 11.8 to 14 in the X-ray diffraction measurement.

The resin composition described above can be used, for example, after being cured. That is, an embodiment of the present invention is a cured body of the above-mentioned resin composition (insulating resin cured body). The cured body may be in a semi-cured state (B stage) or may be in a completely cured state (C stage).

The cured body is obtained by, for example, heat-treating the above-mentioned resin composition to be cured. The conditions for the heat treatment (heating temperature, heating time, and the like) are appropriately set in accordance with the types of the resin and the curing agent, the desired cured state, and the like. The heat treatment may be carried out in one stage or may be carried out in two stages.

The cured body may be, for example, in a sheet form. A cured body in a sheet form is obtained by, for example, applying the above-mentioned resin composition on a substrate and heating (and pressurizing as needed) the resin composition. The cured body in a sheet form may be a B-stage sheet in a semi-cured state, or may be a C-stage sheet in a completely cured state.

The above-mentioned resin composition and a cured body thereof are suitably used for forming an insulating layer of a metal base substrate. That is, the above-described resin composition and a cured body thereof can also be referred to as a resin composition for a metal base substrate and a cured body for a metal base substrate, respectively.

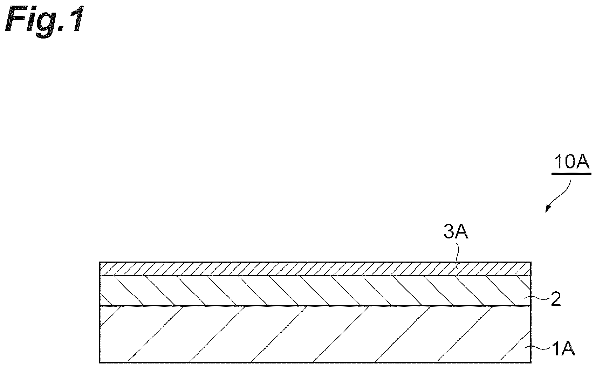

FIG. 1 is a schematic cross-sectional view illustrating an embodiment of a laminate. As shown in FIG. 1, the laminate 10A according to an embodiment includes a first metal layer 1A, an insulating layer (cured body of the above-mentioned resin composition) 2 disposed on one surface of the first metal layer, and a second metal layer 3A disposed on a surface of the insulating layer 2 on the opposite side from the first metal layer. In this laminate 10A, the first metal layer 1A and the second metal layer 3A are separated by the insulating layer 2 and maintain a state of being electrically insulated from each other.

Examples of a metal material constituting the first metal layer 1A include aluminum, an aluminum alloy, copper, a copper alloy, iron, and stainless steel. The first metal layer 1A may be composed of one kind of metal material, or may be composed of two or more kinds of metal materials. The first metal layer 1A may be a single-layer structure or may be a multilayer structure.

Examples of a metal material constituting the second metal layer 3A include copper, aluminum, and nickel. The second metal layer 3A may be composed of one kind of metal material, or may be composed of two or more kinds of metal materials. The second metal layer 3A may have a single-layer structure, or may have a multilayer structure. In FIG. 1, the second metal layer 3A is disposed on substantially the entire surface on the insulating layer 2; however, the second metal layer may be disposed on only a portion of the insulating layer 2.

The thickness of the first metal layer 1A may be, for example, 0.5 mm or more and may be 3 mm or less. The thickness of the insulating layer 2 may be, for example, 50 µm or more and may be 300 µm or less. The thickness of the second metal layer 3A may be, for example, 5 µm or more and may be 1 mm or less.

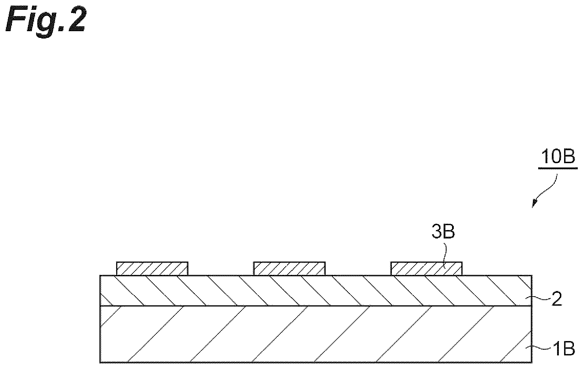

FIG. 2 is a schematic cross-sectional view illustrating an embodiment of a circuit substrate. As shown in FIG. 2, the circuit substrate 10B according to an embodiment includes a metal layer 1B, an insulating layer (cured body of the above-mentioned resin composition) 2 disposed on one surface of the metal layer 1B, and a metal circuit part 3B disposed on a surface of the insulating layer 2 on the opposite side from the metal layer 1B. In this circuit substrate 10B, the metal circuit part 3B is, for example, a circuit processed into a predetermined pattern (for example, etching processing).

Examples of the metal material constituting the metal layer 1B include those similar to the metal material constituting the above-described first metal layer 1A. Examples of the metal material constituting the metal circuit part 3B include those similar to the metal material constituting the above-described second metal layer 3A.

The thickness of the metal layer 1B may be, for example, 0.5 mm or more and may be 3 mm or less. The thickness of the insulating layer 2 may be, for example, 50 µm or more and may be 300 µm or less. The thickness of the metal circuit part 3B may be, for example, 5 µm or more and may be 1 mm or less.

### Examples

Hereinafter, the present invention will be described in more detail by way of Examples; however, the present invention is not intended to be limited to these Examples.

### <Synthesis of copolymer>

The monomers used for the synthesis of the copolymers of Examples are shown below.
((Meth)acrylic monomer A having anionic group)
   · Acrylic acid (manufactured by TOAGOSEI CO., LTD.)
((Meth)acrylic monomer B having cationic group)
   · 1,2,2,6,6-Pentamethyl-4-piperidyl methacrylate ("ADEKA STAB LA-82" manufactured by ADEKA Corporation)
((Meth)acrylic monomer C)
   · Benzyl methacrylate ("LIGHT ESTER BZ" manufactured by Kyoeisha Chemical Co., Ltd.)

First, 100 parts by mass of (meth)acrylic monomers composed of 5 mol% of acrylic acid, 0.1 mol% of 1,2,2,6,6-pentamethyl-4-piperidyl methacrylate, and 94.9 mol% of benzyl methacrylate were added into an autoclave with a stirrer. Next, 0.5 parts by mass (with respect to 100 parts by mass of a sum total of the (meth)acrylic monomers) of azobisisobutyronitrile (manufactured by Tokyo Chemical Industry Co., Ltd.) as an initiator and 1000 parts by mass of a mixed solution of toluene (special grade reagent) and 2-propanol (special grade reagent) (toluene:2-propanol = 7 : 3 (volume ratio)) as a solvent were added thereto, and the atmosphere inside the autoclave was replaced with nitrogen. Thereafter, the autoclave was heated in an oil bath at 65°C for 20 hours, and radical polymerization was carried out. After completion of polymerization, degassing was performed under reduced pressure at 120°C for 1 hour, and a copolymer was obtained.

The polymerization ratio with respect to 100% of the feed amounts of monomers were analyzed by gas chromatography analysis, and the polymerization ratio was 98% or more. From this, the ratio of each monomer unit carried by the copolymer was estimated to be approximately the same as the feed amounts of the monomers.

Furthermore, the weight average molecular weight of the obtained copolymer 1 was determined as the weight average molecular weight calculated relative to polystyrene standards, by using a GPC (gel permeation chromatography) method. The measurement conditions are as follows.
High-performance GPC apparatus: "HLC-8020" manufactured by Tosoh Corporation
Column: One unit of "TSK guard column MP (×L)" manufactured by Tosoh Corporation, 6.0 mm ID × 4.0 cm, and two units of "TSK-GEL MULTIPORE HXL-M" manufactured by Tosoh Corporation, 7.8 mm ID × 30.0 cm (number of theoretical plates: 16000 plates), three units in total (overall number of theoretical plates: 32000 plates)
Developing solvent: Tetrahydrofuran
Detector: RI (differential refractometer)

### <Production of resin composition>

### (Example 1)

27.9% by mass of a naphthalene type epoxy resin HP-4032D (manufactured by DIC Corporation) as a thermosetting resin and 3.5% by mass of a phenol novolac resin VH-4150 (manufactured by DIC Corporation) as a curing agent were stirred at 170°C, and the curing agent was dissolved in the thermosetting resin. The resin in which the curing agent was dissolved, as well as 64.4% by mass (50% by volume) of a boron nitride filler (manufactured by Denka Company Limited, average particle size 40 µm, thermal conductivity 150 W/m·K) as an inorganic filler material, 2.6% by mass (4 phf) of a copolymer, 1.4% by mass (4.5 phr) of an inorganic ion scavenger 1 (IXEPLAS-A1 (Zr, Mg, Al-based), average particle size 0.5 µm, manufactured by TOAGOSEI CO., LTD.) as an inorganic ion scavenger, and 0.2% by mass of 1B2PZ (manufactured by SHIKOKU CHEMICALS CORPORATION) as a curing accelerator were stirred and mixed for 15 minutes in a planetary mixer, and a resin composition was produced.

### <Production of cured body>

The obtained resin composition was applied on a film made of polyethylene terephthalate (PET) and having a thickness of 0.038 mm such that the thickness after curing would be 0.20 mm, the resin composition was heated and dried at 100°C for 50 minutes, and thereby a cured body in a semi-cured state (sheet in a B-stage state) was produced.

### <Production of metal base circuit substrate>

The produced cured body (sheet in a B-stage state) was torn off from the PET film and disposed on a roughened surface of a metal plate (copper plate having a thickness of 2.0 mm), a roughened surface of a metal foil (copper foil having a thickness of 0.5 mm) was disposed on top of the cured body, and the cured body was heated and cured at 180°C for 410 minutes while applying a surface pressure of 10 MPa using a press machine.

Next, a predetermined position was masked with an etching resist, and then the copper foil was etched by using a sulfuric acid hydrogen peroxide mixed solution as an etching solution. The etching resist was removed, and the substrate was washed and dried to obtain a metal base circuit substrate having a circular electrode (copper foil) having a diameter of 20 mm.

### (Example 2)

A resin composition, a cured body, and a metal base circuit substrate were produced by a method similar to that of Example 1, except that an inorganic ion scavenger 2 (IXEPLAS-A2 (Zr, Mg, Al-based), average particle size 0.2 µm, manufactured by TOAGOSEI CO., LTD.) was used as the inorganic ion scavenger.

### (Example 3)

A resin composition, a cured body, and a metal base circuit substrate were produced by a method similar to that of Example 1, except that an inorganic ion scavenger 3 (IXEPLAS-B1 (Zr, Bi-based), average particle size 0.4 µm, manufactured by TOAGOSEI CO., LTD.) was used as the inorganic ion scavenger.

### (Example 4)

A resin composition, a cured body, and a metal base circuit substrate were produced by a method similar to that of Example 1, except that an inorganic ion scavenger 4 (IXE-700F (Mg, Al-based), average particle size 1.5 µm, manufactured by TOAGOSEI CO., LTD.) was used as the inorganic ion scavenger.

### (Example 5)

A resin composition, a cured body, and a metal base circuit substrate were produced by a method similar to that of Example 1, except that an inorganic ion scavenger 5 (IXE-550 (Bi-based), average particle size 1.5 µm, manufactured by TOAGOSEI CO., LTD.) was used as the inorganic ion scavenger.

### (Example 6)

A resin composition, a cured body, and a metal base circuit substrate were produced by a method similar to that of Example 1, except that an inorganic ion scavenger 6 (IXE-100 (Zr-based), average particle size 1.0 µm, manufactured by TOAGOSEI CO., LTD.) was used as the inorganic ion scavenger.

### (Example 7)

A resin composition, a cured body, and a metal base circuit substrate were produced by a method similar to that of Example 1, except that an inorganic ion scavenger 7 (IXE-600 (Sb, Bi-based), average particle size 1.0 µm, manufactured by TOAGOSEI CO., LTD.) was used as the inorganic ion scavenger.

### (Example 8)

A resin composition, a cured body, and a metal base circuit substrate were produced by a method similar to that of Example 1, except that an inorganic ion scavenger 8 (IXE-6107 (Zr, Bi-based), average particle size 1.5 µm, manufactured by TOAGOSEI CO., LTD.) was used as the inorganic ion scavenger.

### (Examples 9 to 15)

A resin composition, a cured body, and a metal base circuit substrate were produced by a method similar to that of Example 3, except that the amount of addition of the inorganic ion scavenger or the copolymer was changed as shown in Tables 2 and 3.

### (Comparative Examples 1 and 2)

A resin composition, a cured body, and a metal base circuit substrate were produced by a method similar to that of Example 3, except that the amount of addition of the inorganic ion scavenger was changed as shown in Table 4.

### (Comparative Examples 3 and 4)

A resin composition, a cured body, and a metal base circuit substrate were produced by a method similar to that of Example 2, except that the amount of addition of the copolymer was changed as shown in Table 4.

### [Measurement of XRD peak]

The cured body produced in each of the Examples and the Comparative Examples was subjected to X-ray diffraction measurement using an X-ray diffraction apparatus "Rigaku MiniFlex II" manufactured by Rigaku Corporation. The position of the XRD peak detected in the range of 2θ = 11 to 15° is shown in Tables 1 to 4.

### [Evaluation of reliability by high-temperature high-voltage bias test (V-t)]

The obtained metal base substrates were subjected to a high-temperature high-voltage bias test (V-t) in an environment at 150°C, in which the time until dielectric breakdown was measured under the test conditions of applying a direct current voltage of 10 kV between the metal foil and the metal plate. The time until dielectric breakdown was defined as the time taken from the start of voltage application to the time point at which the leakage current value measured by a voltage resistance tester reached 10 mA or more.

**[Table 1]**

| | Example 1 | Example 2 | Example 3 | Example 4 | Example 5 |
|---|---|---|---|---|---|
| Amount of addition of copolymer [phf] | 4 | 4 | 4 | 4 | 4 |
| Content of copolymer [% by mass] | 2.6 | 2.6 | 2.6 | 2.6 | 2.6 |
| Type of inorganic ion scavenger | 1 | 2 | 3 | 4 | 5 |
| Inorganic ion scavenger type | Amphoteric ion exchanger | Amphoteric ion exchanger | Amphoteric ion exchanger | Anion exchanger | Anion exchanger |
| Element contained in inorganic ion scavenger | Zr, Mg, Al | Zr, Mg, Al | Zr, Bi | Mg, Al | Bi |
| Amount of addition of inorganic ion scavenger [phr] | 4.5 | 4.5 | 4.5 | 4.5 | 4.5 |
| Content of inorganic ion scavenger [% by mass] | 1.4 | 1.4 | 1.4 | 1.4 | 1.4 |
| Mass ratio (inorganic ion scavenger/copolymer) | 0.53 | 0.53 | 0.53 | 0.53 | 0.53 |
| Position of detected XRD peak (2θ) [°] | 13.17 | 12.51 | 11.93 | 13.69 | 13.92 |
| Time for breakdown in 150°C DC10 kV V-t test [h] | 4.2 | 64.4 | 81.6 | 7.1 | 2.9 |

**[Table 2]**

| | Example 6 | Example 7 | Example 8 | Example 9 | Example 10 |
|---|---|---|---|---|---|
| Amount of addition of copolymer [phf] | 4 | 4 | 4 | 4 | 4 |
| Content of copolymer [% by mass] | 2.6 | 2.6 | 2.6 | 2.6 | 2.6 |
| Type of inorganic ion scavenger | 6 | 7 | 8 | 3 | 3 |
| Inorganic ion scavenger type | Cation exchanger | Amphoteric ion exchanger | Amphoteric ion exchanger | Amphoteric ion exchanger | Amphoteric ion exchanger |
| Element contained in inorganic ion scavenger | Zr | Sb, Bi | Zr, Bi | Zr, Bi | Zr, Bi |
| Amount of addition of inorganic ion scavenger [phr] | 4.5 | 4.5 | 4.5 | 0.5 | 1.5 |
| Content of inorganic ion scavenger [% by mass] | 1.4 | 1.4 | 1.4 | 0.2 | 0.5 |
| Mass ratio (inorganic ion scavenger/copolymer) | 0.53 | 0.53 | 0.53 | 0.06 | 0.18 |
| Position of detected XRD peak (2θ) [°] | 11.98 | 13.97 | 11.91 | 11.93 | 11.93 |
| Time for breakdown in 150°C DC10 kV V-t test [h] | 27.9 | 34.5 | 69.8 | 2.2 | 16.8 |

**[Table 3]**

| | Example 11 | Example 12 | Example 13 | Example 14 | Example 15 |
|---|---|---|---|---|---|
| Amount of addition of copolymer [phf] | 4 | 4 | 4 | 2 | 6 |
| Content of copolvmer [% by mass] | 2.6 | 2.5 | 1.5 | 1.3 | 3.8 |
| Type of inorganic ion scavenger | 3 | 3 | 3 | 3 | 3 |
| Inorganic ion scavenger type | Amphoteric ion exchanger | Amphoteric ion exchanger | Amphoteric ion exchanger | Amphoteric ion exchanger | Amphoteric ion exchanger |
| Element contained in inorganic ion scavenger | Zr, Bi | Zr, Bi | Zr, Bi | Zr, Bi | Zr, Bi |
| Amount of addition of inorganic ion scavenger [phr] | 6 | 10 | 20 | 4.5 | 4.5 |
| Content of inorganic ion scavenger [% by mass] | 1.9 | 3.1 | 6.0 | 1.4 | 1.4 |
| Mass ratio (inorganic ion scavenger/copolymer) | 0.73 | 1.22 | 2.44 | 1.10 | 0.37 |
| Position of detected XRD peak (2θ) [°] | 11.93 | 11.93 | 11.93 | 11.93 | 11.93 |
| Time for breakdown in 150°C DC10 kV V-t test [h] | 84.7 | 196.3 | 38.3 | 70.5 | 65.8 |

**[Table 4]**

| | Comparative Example 1 | Comparative Example 2 | Comparative Example 3 | Comparative Example 4 |
|---|---|---|---|---|
| Amount of addition of copolymer [phf] | 4 | 4 | 0 | 12 |
| Content of copolymer [% by mass] | 2.6 | 2.0 | 0 | 7.3 |
| Type of inorganic ion scavenger | - | 3 | 2 | 2 |
| Inorganic ion scavenger type | - | Amphoteric ion exchanger | Amphoteric ion exchanger | Amphoteric ion exchanger |
| Element contained in inorganic ion scavenger | - | Zr, Bi | Zr, Mg, Al | Zr, Mg, Al |
| Amount of addition of inorganic ion scavenger [phr] | 0 | 100 | 4.5 | 4.5 |
| Content of inorganic ion scavenger [% by mass] | 0 | 24.2 | 1.5 | 1.3 |
| Mass ratio (inorganic ion scavenger/copolymer) | 0 | 12.21 | - | 0.18 |
| Position of detected XRD peak (2θ) [°] | - | 11.93 | 12.51 | 12.51 |
| Time for breakdown in 150°C DC10 kV V-t test [h] | 0.4 | 0.6 | 0.7 | 0.2 |

### Reference Signs List

1A: first metal layer, 1B: metal layer, 2: insulating layer, 3A: second metal layer, 3B: metal circuit part, 10A: laminate, 10B: circuit substrate.

## Claims

1. A resin composition comprising:
a thermosetting resin;
an inorganic filler material;
a copolymer; and
an inorganic ion scavenger,
wherein the copolymer has a (meth)acrylic monomer unit A having an anionic group, a (meth)acrylic monomer unit B having a cationic group, and a (meth)acrylic monomer unit C other than the (meth)acrylic monomer unit A and the (meth)acrylic monomer unit B,
a content of the inorganic ion scavenger is 0.1 to 50 parts by mass with respect to 100 parts by mass of a sum total of the thermosetting resin and the copolymer, and
a content of the copolymer is 0.01 to 10 parts by mass with respect to 100 parts by mass of the inorganic filler material.

2. The resin composition according to claim 1, wherein the inorganic filler material has a thermal conductivity of 20 W/m·K or greater.

3. The resin composition according to claim 1 or 2, wherein a content of the inorganic filler material is 30 to 70% by volume with respect to a total volume of the resin composition.

4. The resin composition according to any one of claims 1 to 3, wherein the inorganic ion scavenger comprises at least one selected from the group consisting of Al, Mg, Bi, Zr, Sb, Sn, Ti, and Zn.

5. The resin composition according to any one of claims 1 to 4, wherein the inorganic ion scavenger has an average particle size of 0.05 to 10 µm.

6. The resin composition according to any one of claims 1 to 5, wherein a mass ratio of the inorganic ion scavenger to the copolymer is 0.001 to 10000.

7. The resin composition according to any one of claims 1 to 6, wherein the resin composition has a peak within a range of 2θ = 11 to 15° in X-ray diffraction measurement.

8. The resin composition according to any one of claims 1 to 7, wherein the thermosetting resin is an epoxy resin.

9. An insulating resin cured body, which is a cured body of the resin composition according to any one of claims 1 to 8.

10. A laminate comprising:
a first metal layer;
an insulating layer disposed on one surface of the first metal layer; and
a second metal layer disposed on a surface of the insulating layer, the surface being on an opposite side of the first metal layer,
wherein the insulating layer is the insulating resin cured body according to claim 9.

11. A circuit substrate comprising:
a metal layer;
an insulating layer disposed on one surface of the metal layer; and
a metal circuit part disposed on a surface of the insulating layer, the surface being on an opposite side of the metal layer,
wherein the insulating layer is the insulating resin cured body according to claim 9.
